Europäisches Patentamt

European Patent Office

Office européen des brevets

(19)

(11) Veröffentlichungsnummer: **0 130 489**
**B1**

(12) EUROPÄISCHE PATENTSCHRIFT

(45) Veröffentlichungstag der Patentschrift: **19.09.90**

(51) Int. Cl.⁵: **H 01 L 23/60**

(21) Anmeldenummer: **84107123.6**

(22) Anmeldetag: **20.06.84**

(54) Rohrförmiger Behälter zur Aufnahme von Halbleiterbauelementen.

(30) Priorität: **30.06.83 DE 3323589**
**08.02.84 DE 3404467**

(43) Veröffentlichungstag der Anmeldung:
**09.01.85 Patentblatt 85/02**

(45) Bekanntmachung des Hinweises auf die
Patenterteilung:
**19.09.90 Patentblatt 90/38**

(84) Benannte Vertragsstaaten:
**AT DE FR GB IT NL**

(56) Entgegenhaltungen:
**FR-A-2 370 403**
**FR-A-2 468 284**
**US-A-4 037 267**
**US-A-4 301 040**
**US-A-4 323 155**
**US-A-4 327 832**

(73) Patentinhaber: **Siemens Aktiengesellschaft**
**Wittelsbacherplatz 2**
**D-8000 München 2 (DE)**

(72) Erfinder: **Walther, Albert, Dipl.-Ing.**
**Ignaz-Güntherstrasse 6**
**D-8150 Holzkirchen (DE)**

Courier Press, Leamington Spa, England.

## Beschreibung

Die Erfindung betrifft einen rohrförmigen Behälter nach dem Oberbegriff des Patentanspruchs 1.

Bekanntlich ist eine elektrostatische Auf- bzw. Entladung häufig der Grund für eine Schädigung oder Zerstörung eines Halbleiterbauelementes. Für elektrostatisch gefährdete Bauelemente verwendet man daher zum Transport und zur Aufbewahrung Behälter mit einem Hohlprofil, in welche die Bauelemente eingeschoben und nacheinander aufgereiht werden, und welche um Aufladungen zu verhindern, aus einem elektrisch leitenden oder einem antistatisch behandelten Material bestehen.

Eine der bekannten Schutzmaßnahmen besteht darin, eine antistatische Behälteroberfläche durch Behandlung mit einer antistatischen Flüssigkeit zu schaffen. Im Lauf der Zeit kann jedoch die so aufgebrachte Schicht ihre Schutzwirkung durch Abrieb oder Verdampfung verlieren. Außerdem ist eine unerwünschte Abhängigkeit von der umgebenden Luftfeuchte zu bemängeln. Ein Nachlassen des Schutzes ist jedoch optisch nicht erkennbar, so daß eine einfache Überwachung nicht möglich ist. Darüberhinaus begünstigen die häufig in dem Antistatikum enthaltenen Halogene, Nitrate oder Sulfate eine Korrosion der metallischen Bausteinanschlüsse.

Weiterhin ist aus der DE-OS 30 39 782 ein Stangenmagazin zur Aufnahme eines Stapels von Schaltelementen bekannt. Diese erhalten dadurch eine reibungsarme und eine triboelektrische Aufladung vermindernde Führung, daß an wenigstens einer Innenwand ein Kontinuierlich in Längsrichtung verlaufender Steg mit Dreieckquerschnitt verläuft. Um jedoch Jeden großflächigen Reibkontakt zwischen den Bausteinen und den Behälterwänden auszuschließen, ist besonders bei sogenannten Dual-In-Line-Gehäusen eine Vielzahl von derartigen Stegen erforderlich. Hinsichtlich der Herstellung der Magazine ist man jedoch bestrebt, möglichst wenige derartige zusätzliche Ausformungen anzubringen.

Eine weitere bereits angewandte Maßnahme ist, alle Behälterwände mittels einer Mischung aus Kunststoff und Ruß (Kohlenstoff) volumenleitend auszubilden. Da ein derartiges Material sehr niederohmig ist, können jedoch die innenliegenden Halbleiterbausteine auch durch äußere Entladung durch die Behälterwände hindurch beschädigt werden. Aufgrund der Kohlenstoffanlagerung muß auch in Kauf genommen werden, daß das Behältermaterial eingeschwärzt ist und somit eine Sichtkontrolle des Magazininhalts ausschließt. Sie hat ferner die unerwünschte Eigenschaft, die mechanische Festigkeit herabzusetzen.

Aus der US-PS 4,327,832 ist dazu ein rohrförmiger Behälter mit U-förmigem Hohlraumquerschnitt zur Aufnahme von Dual-in-line-Halbleiterbauelementen bekannt, bei dem sich an der inneren und äußeren Jochinnenwand Führungsstege in den Jochbereich des Hohlraums hinein erstrecken. Die Form der Führungsstege mit ebenen Oberflächen an ihren Endbereichen verhindert nicht einen vergleichsweise großflächigen Reibkontakt zwischen dem Gehäuse des Bauelements und dem Behälter. Darüberhinaus sind zur Führung des Bauelementgehäuses vergleichsweise viele Führungsstege erforderlich. Die Schutzwirkung des Behälters vor einer Schädigung der Halbleiterbauelemente ist deshalb nicht ausreichend.

Der Erfindung lag die Aufgabe zugrunde, die Schutzwirkung von Behältern der eingangs genannten Art zu verbessern.

Diese Aufgabe wird durch die kennzeichnenden Merkmale des Anspruchs 1 gelöst. Das hat den Vorteil, daß eine Führung der Bauelemente erreicht wird, die den Kontakt mit dem Behälter auf ein Minimum begrenzt, ohne daß eine Vielzahl von einzelnen Gleitstegen ausgebildet werden muß. Der erfindungsgemäße Behälter hält unzulässig hohe, externe Entladungsströme, beispielsweise verursacht von elektrostatisch aufgeladenen Personen, von den Bausteinen fern. Er verhindert auch weitgehend eine triboelektrische Aufladung und schränkt die Materialwahl im Hinblick auf optische Kontrollen des Magazininhalts nicht ein. Wegen seiner guten Gleiteigenschaften ist ein störungsfreies Bestücken und Entleeren bei automatischen Montageeinrichtungen gewährleistet.

Weiterbildungen der Erfindung ergeben sich aus den Unteransprüchen.

Es ist vorgesehen, daß das Behältermaterial einen spez. ohmschen Widerstand von $10^5$—$10^{10}$ Ohm $\times$ cm aufweist. Es ist ferner vorgesehen, die Behälterwände zumindest teilweise aus mindestens zwei abriebfesten Schichten unterschiedlichen spezifischen Widerstandes aufzubauen. Dabei weist die zweite, an der Innenseite des Behälters liegende Schicht einen Oberflächenwiderstand von $10^2$ bis $10^{11}$ Ohm/$\square$ auf. Weiterhin ist im inneren Jochbereich zumindest an der Behälterinnenseite ein elektrisch leitender Ladungskollektor vorgesehen.

Insbesondere hat die Erfindung nach Anspruch 6 den Vorteil, daß durch einen ständigen Ladungsausgleich zwischen den Bausteinanschlüssen eine größere Potentialdifferenz vermieden wird. Eine Gefährdung der Bausteine durch Entladungen außerhalb des Behälters ist durch die Anordnung und die Formgebung der Entladestrecke ausgeschlossen.

Besonders wenn die Behälter als Spender für die Bauteile an weiterverarbeitenden Maschinen dienen, beispielsweise an Bestückautomaten, kann eine Aussparung nach Anspruch 7 vorteilhafterweise dazu dienen, einen symmetrischen und daher bausteinschonenden Ladungsausgleich sicher zu stellen.

Im folgenden wird die Erfindung anhand von fünf Ausführungsbeispielen weiter beschrieben.

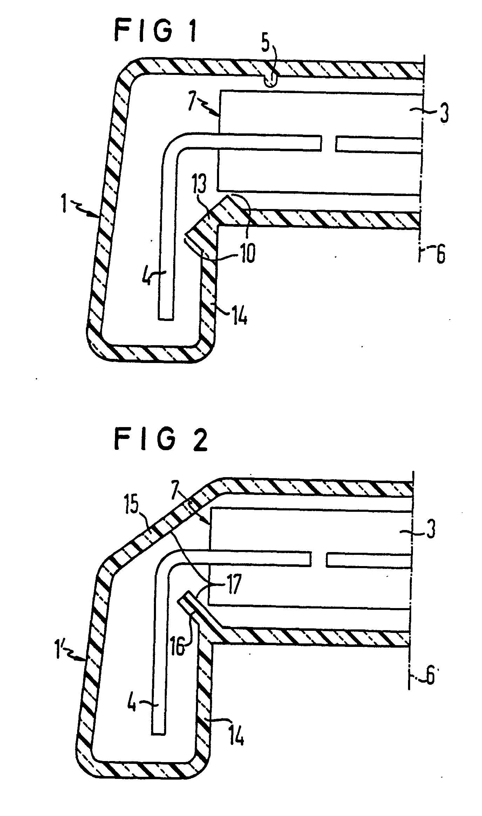

Die FIG 1 bis 5 zeigen bis zu einer Symmetrieachse 6 jeweils einen Querschnitt durch einen rohrförmigen Behälter 1, 1', der ein Halbleiterbauelement 7 enthält. Er ist dazu geeignet, eine Vielzahl derartiger Bauelemente aneinandergereiht in seinem Innenraum aufzunehmen. Ein Zugriff dazu ist - aus den FIG nicht ersichtlich - über Öffnungen an beiden Enden des Behälters 1, 1' möglich.

Das Halbleiterbauelement 7 weist ein Kunststoffgehäuse 3 und zwei Reihen von seitlich aus dem Gehäuse herausführenden und nach unten geneigten metallischen Anschlußbeinchen 4 auf, über welche elektrische Verbindungen zu seinen im Innern liegenden integrierten Schaltkreisen führen. Diese Bauform ist als Dualin-Line-Gehäuse 3, 4 bekannt. Zur Anpassung an diese Form hat der Behälter 1, 1' einen U-förmigen Hohlraumquerschnitt. Das Gehäuse 3 ist durch vier in Längsrichtung des Behälters verlaufende Kanten gekennzeichnet.

Im Behälterinneren verlaufen in Längsrichtung kontinuierlich entlang eines jeden Ansatzes der beiden inneren Schenkel 14 zwei in den Hohlraum ausgeformte Gleitschienen 13. Sie sind mit Gleitkanten 10 versehen, von welchen die eine auf die Unterseite des Gehäuses 3 weist. Gegebenenfalls gleitet das Gehäuse 3 entlang dieser Kanten, beispielsweise bei der Entnahme oder Eingabe des Halbleiterbauelementes 7. Die andere Gleitkante 10 zeigt in Richtung der Anschlußbeinchen 4. Die Schiene ist so ausgeformt, daß weder das Gehäuse 3 noch die Anschlußbeinchen 4 in einen flächigen Reibkontakt mit den Behälter wänden geraten können, auch wenn zu berücksichtigen ist, daß zum Sicherstellen einer Längsbewegung immer ein Spiel zwischen Gehäuse 3 und Behälter 1 vorhanden sein muß. Als Gegenlager dienen parallel zu den Gleitschienen 13 verlaufende Gleitschienen 5 an der der Oberseite des Gehäuses 3 gegenüberliegenden Behälterwand.

In FIG 2 weist der Behälter 1' Gleitflächen 17 auf, die durch ihre Anordnung im Innern und ihre relative Lage zum Halbleiterbauelement 7 ausschließen, daß ein flächiger Kontakt zwischen einer Behälterwand und dem Halbleiterbauelement 7 entstehen kann. Die in Längsrichtung kontinuierlich verlaufenden Gleitflächen 17 sind bezüglich der an die Gehäusekanten angrenzenden Behälter flächen 15 so geneigt, daß lediglich ein auf die Gehäusekanten begrenzter Kontakt entstehen kann. In der FIG beträgt der Neigungswinkel der trapezförmig ausgebildeten Behälter oberseite etwa 45°. Die Gleitflächen 17 müssen in der Breite so ausgedehnt sein, daß diese Bedingungen auch eingehalten sind, wenn das Gehäuse 3 Quer- oder Kippbewegungen ausführt, beispielsweise beim Transport, weil diese wegen des notwendgen Spiels nicht völlig auszuschließen sind.

Im Ausführungsbeispiel gemäß FIG 2 ist jeder der vier betreffenden Gehäusekanten eine derartige Gleitfläche 17 zugeordnet. Diese sind jeweils eben und verlaufen diagonal paarweise parallel. Nicht gezeigt ist eine andere erfindungsgemäße Ausführungsform, bei welcher die Gleitflächen 17 konkav gewölbt sind. Durch diese Maßnahme ist der Neigungswinkel, der durch eine Tangente an den Wölbungsradius bestimmt ist, nicht konstant. Der Verlauf der Wölbung ist so gewählt, daß das Spiel für Kippbewegungen des Halbleiterbauelements 7 relativ zum Behälter 1' möglichst klein wird.

Besonders vorteilhaft ist, wenn die Behälterwände in den entsprechenden Bereichen 15 so verlaufen, daß ihre Innenseiten die Gleitflächen 17 bilden. Ist dies nicht möglich oder erwünscht, sind in den Innenraum herausstehende Gleitschienen 16 ausgebildet. Sie bewirken gegebenenfalls, daß das Gehäuse 3 hohl aufliegt. Wenn sie wie im Ausführungsbeispiel den Kanten an der Unterseite des Gehäuses 3 zugeordnet sind, so sind sie vorteilhafterweise so verbreitet, daß ihr freier Rand auch eine Führung und einen Abstandshalter von der Innenseite der Schenkel 14 für die Anschlußbeinchen 4 bildet.

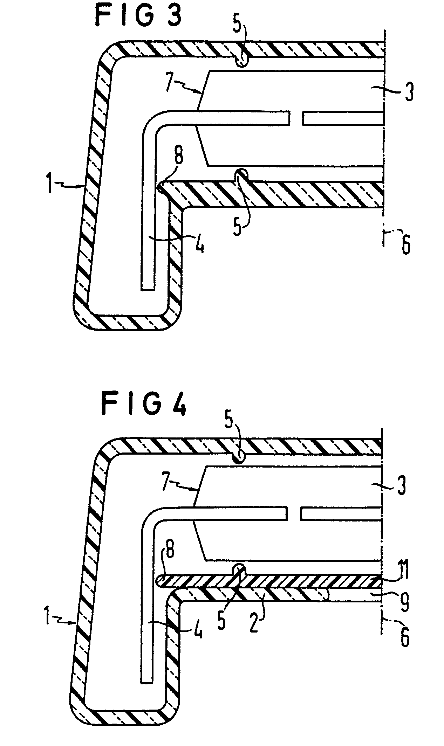

FIG 3 zeigt den Querschnitt eines rohr förmigen Behälters, dessen U-förmiger Hohlraum zur Aufnahme einer Vielzahl von nacheinander in den Hohlraum einzuschiebenden Halbleiterbauelementen 7 ausgebildet ist. Die vollständige Ansicht des Querschnitts ergibt sich wiederum durch Spiegelung der FIG an der Mittellinie 6. An seiner Innenseite sind in Längsrichtung des Behälters 1 erste und zweite Gleitschienen 5, 8 angebracht, welche die Berührungsfläche des Behälters 1 mit dem Gehäuse 3 auf ein Minimum verringern.

Erste Gleitschienen 5 verlaufen parallel oberhalb und unterhalb des Gehäuses 3. Sie halten das Gehäuse 3 in einem solchen Abstand von den Behälterwänden, daß kein großflächiger triboelektrischer Reibungskontakt entsteht. An den inneren Ansatzpunkten der Schenkel mit dem sie verbindenden Joch verlaufen zweite Gleitschienen 8, welche die Anschlußbeinchen 4 in einem definierten Abstand von den Behälterwänden halten. Außerdem wird durch die beiden Gleitschienen 8 eine seitliche Bewegung des Halbleiterbausteins 7 eingeschränkt.

Wie FIG 4 zeigt, weist der Behälter in dem hier wiedergegebenen Beispiel einen hochohmigen Ladungskollektor 11 auf, welcher an der Innenseite des die Schenkel verbindenden Jochs 2 zwischen den Anschlußbeinchen 4 angebracht ist. Der spezifische Widerstand des Ladungskollektors 11 liegt vorzugsweise im Bereich vom $10^2$ bis $10^7$ Ohm × cm. Die Wände des Behälters 1 bestehen vorzugsweise aus transparentem Material.

Aus dem Ladungskollektor 11 ist ein Paar von ersten Gleitschienen 5 ausgeformt, welche sich über die gesamte Länge des Behälters 1 erstrecken. Wie in den FIG 1 und 3 beschrieben minimieren sie die triboelektrische Reibungsfläche zwischen dem Gehäuse 3 und dem Ladungskollektor 11. Ferner ist der Ladungskollektor seitlich über das Joch 2 hinaus verbreitert. so daß die überstehenden Enden zweite Gleitschienen 8 entlang des inneren Ansatzbereiches der Schenkel am dazwischenliegenden Joch 2 bilden. Der Ladungskollektor 11 kontaktiert - gegebenenfalls mit einem zum Ein-bzw. Ausschieben des Halbleiterbauelements 7 aus dem Behälter 1 notwendigen Spiel - die Außenanschlüsse 4 der Halbleiterbauelemente 7.

Symmetrisch zur Mittellinie 6 weist das Joch 2 eine in Längsrichtung des Behälters 1 verlaufende Aussparung 9 auf, durch welche von außen ein elektrischer Kontakt zum Ladungskollektor 11 herstellbar ist. Auf diese Weise kann eine schonende Ladungsableitung durchgeführt werden.

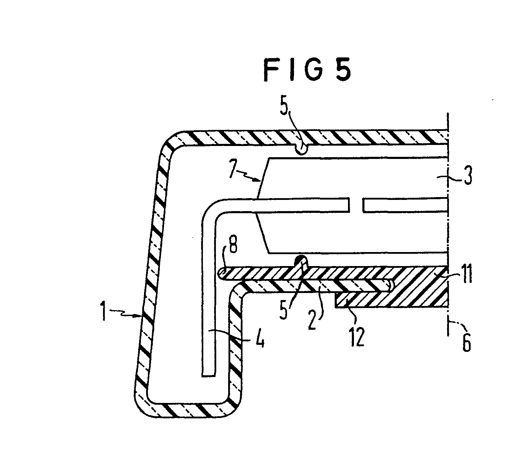

In dem Ausführungsbeispiel, das in FIG 5 dargestellt ist, weist der Ladungskollektor 11 einen H-förmigen Querschnitt auf. Die beiden auf diese Weise gebildeten taschenförmigen Ausnehmungen im Ladungskollektor 11 nehmen die Ränder des Jochs 2 auf, welche die Aussparung 9 begrenzen. Ebenso wie bei der in FIG 2 gezeigten Ausführungsform kann beispielsweise über Kontaktfedern ein Potentialausgleich zu einer Maschine, einem Werkzeug oder ähnlichem herbeigeführt werden.

## Patentansprüche

1. Rohrförmiger Behälter (1, 1') zur Aufnahme und Führung von Halbleiterbauelementen in Dual-in-line Anschlußbeinchen (4) aufweisenden Gehäusen (3) und zu deren Schutz vor elektrostatischer Auf- und Entladung,

mit aus zwei Schenkelabschnitten und einem Jochabschnitt bestehenden, also U-förmigem, Hohlraumquerschnitt und mit sich kontinuierlich in Längsrichtung entlang wenigstens einer Jochinnenwand erstreckenden Gleitschienen,

dadurch gekennzeichnet, daß das Behältermaterial einen spezifischen Widerstand von $10^5$—$10^{17}$ Ohm × cm besitzt und

daß die Behälterinnenwände und die Gleitschienen (5, 8, 13, 16) so ausgebildet und angeordnet sind, daß eine Flächenreibung mit dem Gehäuse (3) und den Anschlußbeinchen (4) ausgeschlossen und lediglich eine auf Kanten begrenzte Berührung möglich ist.

2. Behälter nach Anspruch 1, dadurch gekennzeichnet, daß die Behälterinnenwände und die Gleitschienen (16) Gleitflächen (17) aufweisen, die mit den Kanten des Gehäuses (3) in Berührung kommen.

3. Behälter nach Anspruch 1, dadurch gekennzeichnet, daß die Gleitschienen (5, 13) Gleitkanten (10) aufweisen, die mit den Flächen des Gehäuses (3) in Berührung kommen.

4. Behälter nach Anspruch 2 oder 3, dadurch gekennzeichnet, daß Gleitschienen (5, 8, 13, 16) mit in den Jochabschnitt und in die beiden Schenkelabschnitte des Behälterinnenraums weisenden Kanten ausgeformt sind und Abstandshalter für die Anschlußbeinchen (4) bilden.

5. Behälter nach einem der Ansprüche 1 bis 4, dadurch gekennzeichnet, daß die Behälterränder zumindest teilweise-eine an der Innenseite des Behälters liegende abriebfeste zusätzliche Schicht mit einem Oberflächenwiderstand von $10^2$ Ohm/□ bis $10^{11}$ Ohm/□ aufweisen.

6. Behälter nach einem der Ansprüche 1 bis 5, gekennzeichnet durch einen hochohmigen Ladungskollektor (11), welcher an der Jochinnenwand (2) zwischen den Anschlußbeinchen (4) angeordnet ist.

7. Behälter nach Anspruch 6, dadurch gekennzeichnet, daß die Jochinnenwand eine Aussparung (9) aufweist und daß der Ladungskollektor einen H-förmigen Querschnitt zur Bildung von zwei taschenförmigen Ausnehmungen besitzt, in die die Ränder der Jochinnenwand (2), die die Aussparung (9) bilden, eingreifen.

8. Behälter nach einem der Ansprüche 6 oder 7, dadurch gekennzeichnet, daß aus dem Ladungskollektor (11) Gleitschienen (5, 8) ausgeformt sind.

9. Behälter nach einem der Ansprüche 6 bis 8, dadurch gekennzeichnet, daß der Ladungskollektor (11) einen spezifischen Widerstand von $10^2$ Ohm × cm bis $10^7$ Ohm × cm aufweist.

10. Behälter nach einem der vorhergehenden Ansprüche, dadurch gekennzeichnet, daß die Behälterwände aus einem transparenten Material bestehen.

## Revendications

1. Récipient tubulaire (1, 1')] destiné à recevoir et guider des composants à semiconducteurs dans des boîtiers Dual-in-line (3), comportant des pattes de raccordement (4), et à assurer leur protection vis-à-vis d'une charge et d'une décharge électrostatiques, possédant une section transversale constituée de deux sections formant branches et d'une section formant base, c'est-à-dire en forme de U, et comportant des glissières s'étendant d'une manière continue dans la direction longitudinale le long d'au moins une paroi intérieure de la base, caractérisé par le fait que le matériau du récipient possède une résistance spécifique égale à $10^5$—$10^{10}$ ohms × cm, et que les parois intérieures du récipient et les glissières (5, 8, 13, 16) sont agencées et disposées de manière qu'un frottement superficiel avec le boîtier (3) et les pattes de raccordement (4) est exclu et que seul est possible un contact limité à des arêtes.

2. Récipient suivant la revendication 1, caractérisé par le fait que les parois intérieures du récipient et les glissières (16) possèdent des surfaces de glissement (17), qui viennent en contact avec les arêtes du boîtier (3).

3. Récipient suivant la revendication 1, caractérisé par le fait que les glissières (5, 13) possèdant des arêtes de glissement (10), qui viennent en contact avec les faces du boîtier (3).

4. Récipient suivant la revendication 2 ou 3, caractérisé par le fait que les rails-glissières (5, 8, 13, 16) sont conformées avec des arêtes tournées vers la section formant base et vers les deux sections formant branches de l'espace intérieur du récipient et forment des entretoises pour les pattes de raccordement (4).

5. Récipient suivant l'une des revendications 1 à 4, caractérisé par le fait que les parois du récipient possèdent au moins en partie une couche supplémentaire résistante à l'asure par frottement, qui est située sur la face intérieure du récipient et possède une résistance superficielle comprise entre $10^2$ ohms/□ et $10^{11}$ ohms/□.

6. Récipient suivant l'une des revendications 1 à 5, caractérisé par un collecteur de charges (11) de forte valeur ohmique, qui est disposé sur la paroi intérieure (2) de la base entre les pattes de raccordement (4).

7. Récipient suivant la revendication 6, caractérisé par le fait que la paroi intérieure de la base comporte un évidement (9) et que le collecteur de charges possède une section transversale en forme de H formant deux logements en forme de poches, dans lesquels s'engagent les bords de la paroi intérieure (2) de la base, qui délimitent l'évidement (9).

8. Récipient suivant l'une des revendications 6 ou 7, caractérisé par le fait que les glissières (5, 8) sont formées par moulage à partir du collecteur de charges (11).

9. Récipient suivant l'une des revendications 6 à 8, caractérisé par le fait que le collecteur de charges (11) possède une résistance spécifique comprise entre $10^2$ ohms $\times$ cm et $10^7$ ohms $\times$ cm.

10. Récipient suivant l'une des revendications précédentes, caractérisé par le fait que les parois du récipient sont réalisées en un matériau transparent.

**Claims**

1. Tubular container (1, 1') for receiving and guiding semiconductor components in housings (3) having dual-in-line terminal leads (4), and for protecting them from electrostatic charging and discharging; having a cavity cross-section consisting of two leg portions and one bight portion, thus U-shaped and having glide rails extending continuously in the longitudinal direction along at least one interior wall of the bight, characterized in that the container material possesses a specific resistance of $10^5$—$10^{10}$ ohm $\times$ cm, and in that the interior walls of the container and the glide rails (5, 13, 15) are designed and arranged so that surface friction with housing (3) and the terminal leads (4) is excluded, and only contact limited to edges is possible.

2. Container according to Claim 1, characterized in that the interior walls of the container and the glide rails (15) have glide surfaces (17), which come into contact with the edges of the housing (3).

3. Container according to Claim 1, characterized in that the glide rails (5, 13) have glide edges (10) which come into contact with the surfaces of the housing (3).

4. Container according to Claim 2 or 3, characterized in that guide rails (5, 8, 13, 16) having edges pointing into the bight portion and into the two leg portions of the inside of the container, are formed and form spacers for the terminal leads (4).

5. Container according to one of Claims 1 to 4, characterized in that the container walls have, at least in part, an abrasion-proof additional layer, located on the inside of the container, with a surface resistance of $10^2$ ohm/$\square$ to $10^{11}$ ohm/$\square$.

6. Container according to one of Claims 1 to 5, characterized by a high-resistance charge collector (11), which is disposed on the interior wall of the bight (2) between the terminal leads (4).

7. Container according to Claim 6, characterized in that the interior wall of the bight has an aperture (9), and in that the charge collector possesses an H-shaped cross-section for forming two pocket-shaped recesses, into which the edges of the interior wall of the bight (2), which form the aperture (9), engage.

8. Container according to one of Claims 6 or 7, characterized in that glide rails (5, 8) are formed from the charge collector (11).

9. Container according to one of Claims 6 to 8, characterized in that the charge collector (11) has a specific resistance of $10^2$ ohm $\times$ cm to $10^7$ ohm $\times$ cm.

10. Container according to one of the preceding claims, characterized in that the container walls consist of a transparent material.

FIG 1

FIG 2

# F I G 3

# F I G 4

# F I G 5